# EUROPEAN PATENT APPLICATION

(11) **EP 2 835 469 A1**
(43) Date of publication of application: **11.02.2015**
(21) Application number: 14180231.4
(22) Date of filing: 07.08.2014
(51) Int. Cl.: E01C 13/08, F02G 1/00, H01L 35/00, E01C 13/02

(54) **System for generating electrical energy from heat in an artificial turf**

(30) Priority: 08.08.2013 NL 2011281
(71) Applicant: Bluefinger Holding B.V., 8011 LL Zwolle (NL)
(72) Inventor: Pleijsier, Marco Wilhelm, 8017 BA Zwolle (NL); Veldhuijsen, Martijn, 8011 LL Zwolle (NL)
(74) Representative: Slikker, Wilhelmina Johanna

(57) **Abstract**

The invention relates to an artificial turf, comprising:
- a carrier, and
- a number of artificial grass fibres connected to the carrier and extending therefrom;
wherein
the artificial turf comprises heat-conducting means for conducting heat absorbed by the artificial turf.

The invention also relates to a system for generating electrical energy from heat comprising such an artificial turf, and to a building comprising such a system.

## Description

The invention relates to an artificial turf, comprising:
- a carrier, and
- a number of artificial grass fibres connected to the carrier and extending therefrom.

Such artificial turf is per se known. The per se known artificial turf can become really quite warm under the influence of for instance solar radiation and at high temperatures. The artificial turf can for instance reach a temperature of a maximum of about 50°C.

It is an object of the invention to improve the existing artificial turf.

The artificial turf of the type according to the invention stated in the preamble is provided for this purpose with heat-conducting means for conducting heat absorbed by the artificial turf.

The temperature of the artificial turf can be reduced by conducting heat away from the artificial turf. Alternatively or additionally, heat conducted by the heat-conducting means can be converted to usable energy, such as electrical energy.

In an embodiment of the artificial turf according to the invention the heat-conducting means have a thermal conduction coefficient higher than 5 W/mK, preferably higher than 10 W/mK, more preferably higher than 50 W/mK, still more preferably higher than 100 W/mK. The thermal conduction coefficient of an artificial grass fibre, which can for instance be manufactured from polypropylene (PP), polyethylene (PE), polyamide (PA) or polyethylene terephthalate (PET), usually lies below 1 W/mK, for instance around 0.25 W/mK for PE. The per se known artificial turf hereby has a relatively low thermal conductivity. Addition of the heat-conducting means according to the invention to the artificial turf, which heat-conducting means have a higher thermal conduction coefficient than the artificial grass fibres and/or the carrier, in particular the above stated values, enables heat absorbed by the artificial turf to be conducted efficiently by the heat-conducting means.

The heat-conducting means can for instance comprise a metal, since a number of metals in any case have a relatively high thermal conductivity. The metal can for instance be chosen from the group comprising aluminium, gold, iron, copper, nickel, silver, bronze, brass, steel, zinc and platinum. Alternatively or additionally to the metal, the heat-conducting means can each comprise preferably solid material with a suitable thermal conductivity coefficient such as, though not exclusively, diamond or graphite.

In another embodiment of the artificial turf according to the invention the heat-conducting means comprise a heat-conducting element incorporated in the carrier. The heat-conducting element can extend in the form of for instance a grid or other flat element in the carrier. The heat-conducting element preferably extends here over substantially the whole surface area of the carrier. The heat-conducting element can in this way efficiently conduct heat absorbed by the artificial turf.

In yet another embodiment of the artificial turf according to the invention the heat-conducting means comprise a number of heat-conducting elements incorporated in the artificial grass fibres. The heat-conducting elements extend for instance in a longitudinal direction of the artificial grass fibre, for instance in a core thereof.

In yet another embodiment of the artificial turf according to the invention the heat-conducting means comprise a number of heat-conducting elements, which elements are connected to the carrier and extend therefrom. The heat-conducting elements extend here between the artificial grass fibres. The heat-conducting elements can optionally have a shape and/or colour adapted to the artificial grass fibres such that they are visually difficult to distinguish from the artificial grass fibres and the appearance of the artificial turf is preferably not adversely affected by the heat-conducting elements.

In yet another embodiment of the artificial turf according to the invention the heat-conducting means are connectable to a converting device for converting heat conducted by the heat-conducting means to electrical energy. Heat absorbed by the artificial turf can in this way be usefully applied. The converting device can be incorporated in the artificial turf or remotely thereof.

Practically, the artificial turf comprises a connecting means for connecting the heat-conducting means to a converting device for converting heat conducted by the heat-conducting means to electrical energy. Said connecting means may for example comprise a heat-conducting cable or the like.

The invention also relates to a system for generating electrical energy from heat, comprising
- an artificial turf according to any of the claims 1-6, the artificial turf comprising:
- a carrier;
- a number of fibres connected to the carrier and extending therefrom, and
- heat-conducting means for conducting heat absorbed by the artificial turf,
- a converting device for converting heat to electrical energy,
wherein the heat-conducting means are coupled to the converting device for converting the heat conducted by the heat-conducting means to electrical energy.

Using such a system according to the invention heat absorbed by an artificial turf according to the invention can be usefully applied by being converted to electrical energy using the converting device. The dimensions of artificial turf can be relatively large, whereby a relatively large amount of electrical energy can be produced from solar energy using the system according to the invention.

The converting device can for instance be incorporated in the artificial turf, for instance in the carrier thereof. The converting device can alternatively be disposed remotely of the artificial turf.

The converting device can be chosen from the group comprising a microturbine, a stirling engine and a Seebeck generator. Such converting devices are relatively small, whereby they can be disposed easily in or remotely of the artificial turf. The system can optionally comprise a number of such converting devices.

It is noted that the efficiency of a number of the stated converting devices may be relatively low. However, owing to the relatively large surface area of the artificial turf a relatively large amount of electrical energy can still be produced even with a low-efficiency converting device.

The invention also relates to a building, comprising:
- a system for generating electrical energy from heat according to claim 7 or 8, the system comprising:
   - an artificial turf according to any of the claims 1-6, the artificial turf comprising:
      - a carrier;
      - a number of fibres connected to the carrier and extending therefrom, and
      - heat-conducting means for conducting heat absorbed by the artificial turf,
   - a converting device for converting heat to electrical energy,
wherein the heat-conducting means are coupled to the converting device for converting heat conducted by the heat-conducting means to electrical energy,
wherein the artificial turf is arranged on or at a part of the building.

The artificial turf can for instance be arranged on a (flat) roof of the building. An artificial turf can be aesthetically attractive, and an artificial turf can for instance be aesthetically more attractive than solar cells. Electrical energy can be produced by arranging the system according to the invention on or at a building, wherein the aesthetic quality of the building can be retained or possibly even enhanced.

It is noted that the artificial turf according to the invention can particularly be a decorative artificial turf.

The invention is further elucidated with reference to the figures shown in a drawing, in which:
figure 1 shows schematically a system according to an embodiment of the invention;
figure 2 shows a section through a carrier of an artificial turf according to a second embodiment of the artificial turf according to the invention;
figures 3A and 3B show respectively a longitudinal section and a cross-section of an artificial grass fibre of an artificial turf according to a third embodiment of the artificial turf according to the invention.

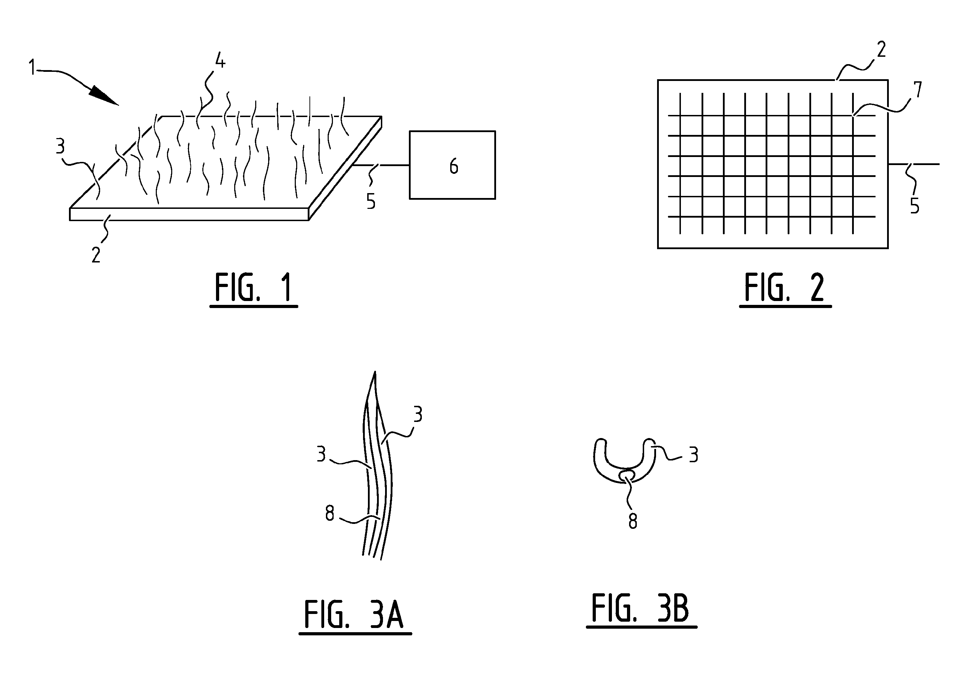

Figure 1 shows a system according to the invention. The system comprises an artificial turf 1 with a carrier 2 and a number of artificial grass fibres 3 connected to carrier 2 and extending therefrom. Artificial turf 1 comprises a number of heat-conducting elements 4 which are likewise connected to carrier 2 and extend therefrom. Heat-conducting elements 4 extend between the artificial grass fibres 3. Heat-conducting elements 4 are preferably shaped such that at least visually they cannot be distinguished from the artificial grass fibres, or hardly so. Heat-conducting elements 4 comprise for instance metal wires or fibres. Heat-conducting elements 4 are coupled via a connecting means in the form of a heat-conducting cable 5 or the like to a converting device 6 for converting heat to electrical energy. Heat-conducting elements 4 are configured here to conduct heat absorbed by artificial turf 1 via cable 5 to converting device 6 such that heat conducted by heat-conducting elements 4 and cable 5 is converted to electrical energy. Device 6 is shown schematically and can for instance comprise a microturbine, a stirling engine or a Seebeck generator. The system can optionally comprise a number of such converting devices 6, wherein the same or different types of device 6 can be provided. In figure 1 the converting device 6 is disposed remotely of artificial turf 1. It will be apparent that it can optionally be disposed in the artificial turf 1, for instance in carrier 2. Converting device 6 can in that case preferably take a flat form so that it can be easily incorporated into carrier 2.

Heat-conducting elements 4 can conduct heat absorbed by carrier 2 and/or by artificial grass fibres 3, as well as being able itself to collect solar radiation and conduct the thereby generated heat. Both options are seen in the context of this invention as heat absorbed by the artificial turf.

Figure 2 shows a section of a carrier 2. Carrier 2 comprises a grid-like heat-conducting element 7 incorporated in the carrier. The grid-like heat-conducting element 7 extends over substantially the whole surface area of carrier 2. Element 7 is connected to a cable 5, using which the element 7 can be connected to a device for converting heat to electrical energy, see figure 1. Carrier 2 can for instance comprise a first flat carrier element and a second flat carrier element, wherein element 7 is disposed between the two carrier elements. The carrier elements can for instance be connected along their periphery to each other. The artificial grass fibres can for instance be connected to one of the two carrier elements such that attachments of the artificial grass fibres to the carrier extend between the two carrier elements and are not therefore visible externally.

Figures 3A and 3B show respectively a longitudinal section and a cross-section of an artificial grass fibre 3 in which a heat-conducting element 8 is incorporated. The element extends in longitudinal direction in the core of artificial grass fibre 3 over at least a part of the length thereof. It may be the case that each artificial grass fibre 3 of an artificial turf comprises such an element 8 or that a number of artificial grass fibres of an artificial turf comprise such an element 8. Element 8 or elements 8 can be coupled to a cable 5 in order to conduct the heat to a converting device.

Heat-conducting elements 4 and/or heat-conducting elements 7 and/or heat-conducting elements 8 can optionally be combined in one artificial turf. An artificial turf can for instance comprise a heat-conducting element 7 in the carrier as well as one or a number of heat-conducting elements 4 and/or heat-conducting elements 8, wherein conducting elements 4 and/or heat-conducting elements 8 are connected for thermal conduction to heat-conducting element 7. The heat from heat-conducting elements 4 and/or heat-conducting elements 8 can in this way be conducted in simple manner via the heat-conducting element 7 that is connected to a cable 5.

It is noted that the invention is not limited to the shown embodiments but also extends to variants within the scope of the appended claims.

## Claims

1. Artificial turf, comprising:
- a carrier, and
- a number of artificial grass fibres connected to the carrier and extending therefrom;
**characterized in that**
the artificial turf comprises heat-conducting means for conducting heat absorbed by the artificial turf.

2. Artificial turf as claimed in claim 1, wherein the heat-conducting means have a thermal conduction coefficient higher than 5 W/mK, preferably higher than 10 W/mK, more preferably higher than 50 W/mK, still more preferably higher than 100 W/mK.

3. Artificial turf as claimed in claim 1 or 2, wherein the heat-conducting means comprise a heat-conducting element incorporated in the carrier.

4. Artificial turf as claimed in any of the foregoing claims, wherein the heat-conducting means comprise a number of heat-conducting elements incorporated in the artificial grass fibres.

5. Artificial turf as claimed in any of the foregoing claims, wherein the heat-conducting means comprise a number of heat-conducting elements, which elements are connected to the carrier and extend therefrom.

6. Artificial turf as claimed in any of the foregoing claims, comprising a connecting means for connecting the heat-conducting means to a converting device for converting heat conducted by the heat-conducting means to electrical energy.

7. System for generating electrical energy from heat, comprising
- an artificial turf as claimed in any of the claims 1-6, the artificial turf comprising:
- a carrier;
- a number of fibres connected to the carrier and extending therefrom, and
- heat-conducting means for conducting heat absorbed by the artificial turf,
- a converting device for converting heat to electrical energy,
wherein the heat-conducting means are coupled to the converting device for converting the heat conducted by the heat-conducting means to electrical energy.

8. System as claimed in claim 7, wherein the converting device is incorporated in the artificial turf, for instance in the carrier.

9. System as claimed in claim 7 or 8, wherein the converting device is chosen from the group comprising a microturbine, a stirling engine and a Seebeck generator.

10. Building, comprising:
- a system for generating electrical energy from heat as claimed in any of the claims 7-9, the system comprising:
- an artificial turf according to any of the claims 1-6, the artificial turf comprising:
- a carrier;
- a number of fibres connected to the carrier and extending therefrom, and
- heat-conducting means for conducting heat absorbed by the artificial turf,
- a converting device for converting heat to electrical energy,
wherein the heat-conducting means are coupled to the converting device for converting heat conducted by the heat-conducting means to electrical energy,
wherein the artificial turf is arranged on or at a part of the building.
